(19) Europäisches Patentamt
European Patent Office
Office européen des brevets

(11) **EP 1 791 692 B1**

(12) **EUROPEAN PATENT SPECIFICATION**

(45) Date of publication and mention
of the grant of the patent:
**12.06.2019 Bulletin 2019/24**

(51) Int Cl.:
***B32B 15/08*** (2006.01)

(21) Application number: **05856337.0**

(22) Date of filing: **21.09.2005**

(86) International application number:
**PCT/KR2005/003125**

(87) International publication number:
**WO 2006/080626 (03.08.2006 Gazette 2006/31)**

(54) **METALLIC LAMINATE AND METHOD FOR PREPARING THEREOF**

METALLISCHES LAMINAT UND HERSTELLUNGSVERFAHREN DAFÜR

STRATIFIE METALLIQUE ET PROCEDE DE PREPARATION ASSOCIE

(84) Designated Contracting States:
**AT BE BG CH CY CZ DE DK EE ES FI FR GB GR HU IE IS IT LI LT LU LV MC NL PL PT RO SE SI SK TR**

(30) Priority: **21.09.2004 KR 20040075635**

(43) Date of publication of application:
**06.06.2007 Bulletin 2007/23**

(73) Proprietor: **Shengyi Technology Co., Ltd.
Guangdong 523808 (CN)**

(72) Inventors:
• **KO, Joo-eun**
**Yuseong-gu,**
**Daejeon 305-308 (KR)**
• **PARK, Soon-yong**
**Yuseong-gu,**
**Daejeon 305-340 (KR)**
• **SONG, Heon-sik**
**Yuseong-gu,**
**Daejeon 305-308 (KR)**

(74) Representative: **Hoffmann Eitle
Patent- und Rechtsanwälte PartmbB
Arabellastraße 30
81925 München (DE)**

(56) References cited:
**EP-A- 0 498 898    WO-A1-2004/085146
JP-A- 01 244 841    US-A- 4 963 428
US-A- 5 112 694**

**Description**

**Technical Field**

The present invention relates to a metallic laminate for printed-circuit base board and a preparation method thereof, more precisely, a metallic laminate for printed-circuit base board showing excellent dimensional stability against temperature change and reliability of adhesive force and uniformity before and after etching that is composed of two low thermal expansion polyimide resin layers having thermal expansion coefficient of up to 20 ppm/°C, a metallic conductor layer and a high thermal expansion polyimide resin layer having thermal expansion coefficient of more than 20 ppm/°C loaded over the low thermal expansion polyamide resin layers, and a preparation method of the same.

**Background Art**

According to a trend of miniaturization and multifunctionalization of electronic machines, in particular in the field of portable instruments, high density printed-circuit base boards are required to produce electronic equipments. To meet the need, multilamination of circuit board has been generally applied. In addition, flexible printed-circuit base board which can be established in a narrow space and narrow line circuit to secure large numbers of circuits in a limited space has also been used. In the meantime, to avoid environmental problems caused by soldering for multilamination, an adhesive not including lead is now a primary concern. So, it is highly required to develop an adhesive for multilamination of circuit board which has high adhesive force, thermal resistance and low absorption rate.

As proved in Korean Patent Application No. 2000-73384 (Applicant: LG Chem, Ltd., Korea), the conventional metallic laminates prepared by adhering polyimide film and metal foil with the acryl or epoxy adhesive are inappropriate to be used in circuit boards asking multilamination, flexibility, high adhesive force and thermal resistance. Thus, double layer flexible metallic laminate in which polyimide and metal foil are directly adhered on each other without an adhesive has been developed.

The double layer metallic laminate is formed by direct adhesion of metal foil, more preferably copper (Cu) foil, with polyimide film without using an adhesive. Therefore, unlike the conventional 3CCL (3-layer copper clad laminate) in which copper foil and polyimide film are adhered on each other by an adhesive, the double layer metallic laminate showing thermal stability and excellent durability and electronic properties is a very promising candidate for a flexible circuit base board material.

Numbers of study results on such double layer metallic laminate have been reported. At first, 2CCL (2-Layer Copper Clad Laminate) was produced by using copper foil as a metallic conductor. At that time, polyimide resin having bigger thermal expansion coefficient than 20ppm/°C was loaded on copper foil, affecting dimensional stability with the temperature change that means the laminate contracts or expands when temperature goes up or down.

Regarding flexible printed-circuit base board, the one with unilateral structure having a conductor layer on one side and the other with bilateral structure having conductor layers on both sides leaving insulator layer in between them have been put to practical use. However, the laminate having bilateral structure has low flexibility, compared with flexible printed-circuit base board having unilateral structure.

EP-A-0 498 898 discloses a flexible metal-clad laminate obtained by directly applying a polyimide precursor to a metallic conductive foil, and then drying, heating and curing the precursor to form a polyimide film. The laminate is characterized by the polyimide film being composed of two or more polyimide layers, the linear thermal expansion coefficient of at least one of the second and later polyimide layers being larger than that of the first layer brought into contact with the metallic conductive foil, and the requirements of the following formulae are met:

$$3.0 < Q_{n-1} \times t_n < 50$$

and

$$t_{n-1} > t_n$$

wherein $t_n$ is the thickness ($\mu$m) of the outermost layer (the nth layer) of the polyimide layers, $t_{n-1}$ is the thickness ($\mu$m) of the film comprising the first layer to the (n-1)th layer of the polyimide layers, and $Q_{n-1}$ is a double value (cm) of the curvature radius of the curl of the film comprising the first layer to the (n-1)th layer of the polyimide layers.

JP-A-01-244841, corresponding to EP-A-0 335 337, discloses a flexible printed circuit base material comprising at least one layer of a polyimide resin having a low thermal expansion, at least one layer of a polyimide resin having a high thermal expansion and a higher linear expansion coefficient than the said polyimide resin with a low thermal expansion, and at least one layer of a conductor.

**Disclosure of the Invention**

The present inventors made every effort to overcome the above problems of the conventional metallic laminate for printed-circuit base board. As a result, the present inventors completed this invention by confirming that the multiple laminates of insulator with polyimide resins having different thermal expansion coefficients on metallic conductor layer enables the production of double layer metallic laminate showing excellent dimensional stability even with the temperature changes, and reliability of adhesive force, uniformity before and after etching, and chemical resistance. More precisely, the present inventors proved that double layer metallic laminate having excellent properties such as dimensional stability, adhesive force, uniformity, and chemical resistance can be produced by realizing multiple laminates by loading high thermal expansion polyimide resin having thermal expansion coefficient of more than 20 ppm/°C on two low thermal expansion polyimide resins having thermal expansion coefficient of up to 20 ppm/°C.

According to a first aspect, the present invention provides a metallic laminate consisting of a conductor layer, a first polyimide resin layer whose thermal expansion coefficient is 5-16 ppm/°C, a second polyimide resin layer whose thermal expansion coefficient is 16-20 ppm/°C, the thermal expansion coefficients of the first and second polyimide resin layers differing by at least 3 ppm/°C, and optionally a third polyimide resin layer whose thermal expansion coefficient is more than 20 ppm/°C coated on the first and second polyimide resin layers, the difference between the thermal expansion coefficient of the second polyimide resin layer and the thermal expansion coefficient of the third polyimide resin layer being at least 10 ppm/°C.

wherein the first and second polyimide resin layers are produced from polyimide precursor solutions prepared from one or more dianhydrides selected from pyromellitic dianhydride (PMDA), 3,3,4,4-biphenyltetracarboxylic dianhydride (BPDA), 3,3,4,4-benzophenontetracarboxylic dianhydride (BTDA), 4,4-oxydiphthalic anhydride (ODPA), 4,4-(4,4-isopropylbiphenoxy)biphthalic anhydride (BPADA), 2,2-bis-(3,4-dicarboxylphenyl) hexafluoropropane dianhydride (6FDA) and ethyleneglycol bis(anhydro-trimellitate (TMEG), and one or more diamines selected from p-phenylenediamine (p-PDA), m-phenylenediamine (m-PDA), 4,4-oxydianiline (4,4-ODA), 3,4'-oxydianiline (3,4'-ODA), 2,2-bis(4-[4-aminophenoxy]-phenyl)propane (BAPP), 1,3-bis(4-aminophenoxy)benzene (TPE-R), 2,2-bis(4-[3-aminophenoxy]phenyl)sulfone (m-BAPS), 3,3'-dihydroxy-4,4'-diamino biphenyl (HAB) and 4,4'-diaminobenzanilide (DABA), the dianhydride and the diamine being mixed in a molar ratio 1 : 0.9-1.1 in an organic solvent.

Preferably the ratio of the thickness of the first polyimide resin layer to the thickness of the second polyimide resin is 1:0.01-100.

Preferably the conductor layer is copper foil.

According to a second aspect, the present invention provides a method for preparing a metallic laminate comprising the steps of:

(i) coating a metal foil with a polyimide precursor solution,
(ii) drying the solution,
(iii) coating with another polyimide precursor solution,
(iv) drying the solution, and
(v) hardening to load two polyimide resin layers on the metal foil,

one polyimide resin layer (I) having a thermal expansion coefficient of 5-16 ppm/°C and the other polyimide resin layer (II) having a thermal expansion coefficient of 16-20 ppm/°C, the thermal expansion coefficients of the polyimide resin layers (I) and (II) differing by at least 3 ppm/°C,
wherein the first and second polyimide resin layers are produced from a polyimide precursor solutions prepared from one or more dianhydrides selected from pyromellitic dianhydride (PMDA), 3,3,4,4-biphenyltetracarboxylic dianhydride (BPDA), 3,3,4,4-benzophenontetracarboxylic dianhydride (BTDA), 4,4-oxydiphthalic anhydride (ODPA), 4,4-(4,4-isopropylbiphenoxy)biphthalic anhydride (BPADA), 2,2-bis-(3,4-dicarboxylphenyl) hexafluoropropane dianhydride (6FDA) and ethyleneglycol bis(anhydro-trimellitate (TMEG), and one or more diamines selected from p-phenylenediamine (p-PDA), m-phenylenediamine (m-PDA), 4,4-oxydianiline (4,4-ODA), 3,4'-oxydianiline (3,4'-ODA), 2,2-bis(4-[4-aminophenoxy]-phenyl)propane (BAPP), 1,3-bis(4-aminophenoxy)benzene (TPE-R), 2,2-bis(4-[3-aminophenoxy]phenyl)sulfone (m-BAPS), 3,3'-dihydroxy-4,4'-diamino biphenyl (HAB) and 4,4'-diaminobenzanilide (DABA), the dianhydride and the diamine being mixed in a molar ratio 1 : 0.9-1.1 in an organic solvent.

Preferably the method further comprises the steps of coating the metal foil coated with both polyimide precursor solutions with a third polyimide precursor solution, and drying the solution, the third polyimide precursor solution forming a polyimide resin layer (III) whose thermal expansion coefficient is more than 20 ppm/°C, the thermal expansion coefficients of layers (III) and (II) differing by at least 10 ppm/°C.

Preferably the ratio of the thickness of the polyimide resin layer (I) to the thickness of the polyimide resin layer (II) is 1:0.01-100.

Preferably the metal foil is copper foil.

Metals usable for the metallic laminate of the present invention are exemplified by copper, aluminum, iron, silver, palladium, nickel-chrome, molybdenum, tungsten or their alloys, and among these, copper is most preferred candidate.

Metallic laminate having a bilateral structure is also acceptable herein, but the metallic laminate having a unilateral structure is more preferred to accomplish the object of the invention.

In the present invention, the preferable thickness ratio of the first low thermal expansion polyimide resin to the second low thermal expansion polyimide resin is in the range of 0.01 to 100. If the difference of thickness ratio is less than 0.01 or more than 100, the product has curl, which is even differently expressed after etching, resulting in difficulties in circuit formation.

Polyimide precursor solution used in the present invention is prepared in the form of varnish in which dianhydride and diamine are mixed at the molar ratio of 1:0.9 or 1:1.1 in a proper organic solvent. Metal plate is coated with that varnish at least once and then dried, resulting in a resin layer. The desirable thermal expansion coefficient of a polyimide resin of the invention can be obtained by regulating the mixing ratio of dianhydride to diamine or the mixing ratios between dianhydrides or between diamines, or the kinds of candidate dianhydride and diamine in polyimide precursor solution.

The diamine of the present invention can be one or more compounds selected from a group consisting of p-phenylenediamine (p-PDA), m-phenylenediamine (m-PDA), 4,4-oxydianiline (4,4-ODA), 3,4'-oxydianiline (3,4'-ODA), 2,2-bis(4-[4-aminophenoxy]-phenyl)propane (BAPP), 1,3-bis(4-aminophenoxy)benzene (TPE-R), 2,2-bis(4-[3-aminophenoxy]phenyl)sulfone (m-BAPS), 3,3'-dihydroxy-4,4'-diamino biphenyl (HAB) and 4,4'-diaminobenzanilide (DABA).

In addition to the dianhydrides and diamines described in connection with the above first and second aspects, other kinds of dianhydrides or diamines, or other compounds can be additionally added in the present invention.

An organic solvent useful for preparing polyimide precursor solution is selected from a group consisting of N-methylpyrrolidinone (NMP), N,N-dimethylacetamide (DMAc), tetrahydrofuran (THF), N,N-dimethylformamide (DMF), dimethylsulfoxide (DMSO), cyclohexane, acetonitrile and a mixture thereof, but not always limited thereto.

The preferable content of polyimide precursor in a whole solution is 10-30 weight%. When the content is less than 10 weight%, the use of unnecessary solvent is increased. In the meantime, the content of the precursor more than 30 weight%, viscosity of the whole solution is increased too high to spread evenly.

To facilitate spreading or hardening or to enhance other properties, antifoaming agent, antigelling agent, hardening accelerator, etc, can be additionally included in the resin of the invention.

To perform coating with polyimide precursor solution, die coater, comma coater, reverse comma coater, gravure coater, etc can be used. Besides, other conventional techniques for coating can also be used. The coated varnish is dried in an arch type oven or in a floating type oven at the temperature under boiling point of a solvent, which is 100-350°C, more preferably at 140-250°C, even though the temperature has to be adjusted according to the structure or conditions of an oven.

As explained above, one section of metal foil is coated with low thermal expansion polyimide precursor or high thermal expansion polyimide precursor and dried. Then, the temperature is raised to 350°C, leading to hardening. Hardening of metal foil is induced by raising the temperature slowly in an oven in the presence of nitrogen or in vacuum condition or by making the metal foil pass through high temperature continually.

So, excellent flexible double layer metallic laminate for printed-circuit base board has been produced by the method of the present invention.

The double layer metallic laminate prepared by the present invention has excellent chemical resistance and at least 0.5 kg/cm of adhesive force, up to 4% of moisture absorption rate, at least $13.8 \times 10^7$ Pa of tensile strength, at least 25% of elongation percentage and up to 0.5% of stretch thermal contraction rate.

**Best Mode for Carrying Out the Invention**

Practical and presently preferred embodiments of the present invention are illustrative as shown in the following Examples.

However, it will be appreciated that those skilled in the art, on consideration of this disclosure, may make modifications and improvements within the spirit and scope of the present invention.

Polyimide precursor solutions were synthesized to prepare metallic laminate in Examples and Comparative Examples of the invention and their properties were compared.

[Synthetic Example 1]

5.2 g of p-PDA and 0.2 g of 4,4'-ODA were dissolved in 100 ml of N-methylpyrrolidinone, to which 14.6 g of BPDA was added, followed by stirring for 24 hours for polymerization. The temperature for polymerization was set to 5°C. The temperature of the reaction solution was raised to 350°C to induce hardening, resulting in 25 $\mu$m thick film. While raising the temperature by 10°C/minute, coefficient of linear expansion of the film was measured by using TMA. As a result, the average coefficient of linear expansion of the product in the temperature range between 100°C to 200°C was 9 ppm/°C.

[Synthetic Examples 2-11]

Polyimide precursor solutions were prepared by using dianhydride and diamine, shown in Table 1, by the same method as described in Synthetic Example 1, and their coefficients of linear expansion were measured.

[Table 1]

| | Dianhydride (g) | | Diamine (g) | | Coefficient of linear expansion x 10⁻⁶ (1/°C) |
|---|---|---|---|---|---|
| Synthetic Example 2 | BPDA 10.7 | BTDA 4.2 | p-PDA 5.1 | - | 16 |
| Synthetic Example 3 | BPDA 10.1 | ODPA 4.6 | p-PDA 5.3 | - | 13 |
| Synthetic Example 4 | PMDA 6.6 | BTDA 4.2 | 4,4'-ODA 1.7 | HAB 7.5 | 17 |
| Synthetic Example 5 | BPDA 6.9 | BTDA 7.5 | p-PDA 4.5 | DABA 1.1 | 13 |
| Synthetic Example 6 | BPDA 6.8 | ODPA 7.1 | p-PDA 4.0 | DABA 2.1 | 16 |
| Synthetic Example 7 | BPDA 4.5 | PMDA 6.2 | 4,4'-ODA 2.6 | HAB 6.6 | 10 |
| Synthetic Example 8 | BPDA 11.9 | BPADA 2.3 | TPE-R 1.3 | p-PDA 4.4 | 19 |
| Synthetic Example 9 | BPDA 6.5 | BTDA 7.1 | p-PDA 3.3 | DABA 3 | 18 |
| Synthetic Example 10 | BPDA 10.3 | TMEG 1.6 | 4,4'-ODA 3.9 | HAB 4.2 | 30 |
| Synthetic Example 11 | BPDA 14.3 | | 4,4'-ODA 1.0 | p-PDA 4.7 | 8 |

[Example 1]

Copper foil was coated with polyimide precursor solution, prepared in Synthetic Example 1, to make it as thick as shown in Table 2 after hardening. After drying at 140°C, it was coated again with polyimide precursor solution prepared in Synthetic Example 2, by the same method as described above, followed by drying. Then, the temperature was raised to 350°C to induce hardening. Adhesive force and expansion rate were measured. The laminate passed the tests of chemical resistance and uniformity before and after etching.

[Examples 2-7]

As shown in Table 2, polyimide precursor solutions were used to produce double layer copper clad laminate by the same method as described in Example 1. Then, adhesive force and expansion rate were measured and the results are shown in Table 2. The double layer copper clad laminates produced in Examples 2-7 passed the tests of chemical resistance and uniformity before and after etching.

[Comparative Example 1]

Copper foil was coated with polyimide precursor solution, prepared in Synthetic Example 1, to make it 0.2 $\mu$m thick after hardening. After drying at 140°C, it was coated again with polyimide precursor solution prepared in Synthetic Example 2, by the same method as described above, resulting in a thickness of 24.8 $\mu$m, followed by drying. Then, the temperature was raised to 350°C to induce hardening. At that time, polyimide thin film including a conductor layer was not flat.

[Table 2]

|  | First layer | | Second layer | | Adhesive force (kg/cm) | Expansion rate (%) | Moisture absorption rate (%) |
|---|---|---|---|---|---|---|---|
|  | Solution | Thickness ($\mu$m) | Solution | Thickness ($\mu$m) | | | |
| Example 1 | Synthetic Example 1 | 13 | Synthetic Example 2 | 12 | 1.1 | 0.4 | 2.5 |
| Example 2 | Synthetic Example 11 | 8 | Synthetic Example 8 | 17 | 1.0 | 0.5 | 2.4 |
| Example 3 | Synthetic Example 3 | 10 | Synthetic Example 4 | 10 | 1.2 | -0.4 | 2.2 |
| Example 4 | Synthetic Example 5 | 6 | Synthetic Example 2 | 6.5 | 1.0 | 0.3 | 2.2 |
| Example 5 | Synthetic Example 6 | 11 | SyntheticExample 7 | 14 | 1.3 | 0.4 | 2.3 |
| Example 6 | Synthetic Example 8 | 12 | Synthetic Example 5 | 8 | 1.5 | 0.4 | 2.5 |
| Example 7 | Synthetic Example 9 | 5.5 | Synthetic Example 7 | 7 | 1.2 | -0.3 | 2.2 |

[Example 8]

Copper foil was coated with polyimide precursor solution, prepared in Synthetic Example 9, to make it 12 $\mu$m thick after hardening. After drying at 140°C, it was coated again with polyimide precursor solution prepared in Synthetic Example 5, by the same method as described above, followed by drying. The coated copper foil was made 11 $\mu$m thick after hardening. Then, the copper foil was coated with polyimide precursor solution, prepared in Synthetic Example 10, to make it 2 $\mu$m thick after hardening, followed by drying with the same method as described above. The temperature was then raised to 350°C, resulting in hardening of the thin film. The produced double layer copper clad laminate has 1.3 kg/cm of adhesive force, 0.5% of expansion rate, 3% of moisture absorption rate, and 28% of elongation percentage, and chemical resistance and uniformity before and after etching were proved good.

[Comparative Example 2]

Copper foil was coated with polyimide precursor solution, prepared in Synthetic Example 3, to make it 20 $\mu$m thick after hardening. After drying the coated copper foil at 140°C, the temperature was raised to 350°C to induce hardening. The expansion rate of the produced double layer copper clad laminate was 0.6%, and the polyimide thin film including a conductor layer was not flat.

[Comparative Example 3]

Copper foil was coated with polyimide precursor solution, prepared in Synthetic Example 10, to make it 20 $\mu$m thick after hardening. After drying the coated copper foil at 140°C, the temperature was raised to 350°C to induce hardening. The expansion rate of the produced double layer copper clad laminate was 1.0%, and the polyimide thin film including a conductor layer was not flat.

[Comparative Example 4]

Copper foil was coated with polyimide precursor solution, prepared in Synthetic Example 10, to make it 3 $\mu$m thick after hardening. After drying at 140°C, it was coated again with polyimide precursor solution prepared in Synthetic Example 3, by the same method as described above, followed by drying. The coated copper foil was made 22 $\mu$m thick after hardening. Then, the temperature was raised to 350°C to induce hardening. The expansion rate of the produced double layer copper clad laminate was 1.2%. At that time, polyimide thin film including a conductor layer was not flat, and polyimide thin film including copper foil was not flat, either.

[Measurement of adhesive force, expansion rate, chemical resistance, moisture absorption rate, and uniformity before and after etching]

The measurement of each property was performed based on IPC-FC-241C.

    1) Adhesive force: 2.4.9 peel strength
    2) Expansion rate: 2.2.4. Dimensional stability
    3) Chemical resistance: 2.3.2. Chemical Resistance of flexible print wiring

The following chemicals were prepared in that order, and the prepared polyimide film was dipped serially in each chemical solution for 1 minute per each. The film was washed with 55°C water and tackiness, blistering, bubbles, delamination, swelling, color change were observed within 30 minutes. 16-24 hours later, observation was performed again and in particular peel strength was measured both in the film exposed on chemicals and in the film not exposed on chemicals. No change on film was regarded as passing through chemical resistance test.
Monoethanol amine 0.5%/KOH 5.0%/monobutylether 0.5% solution, 55±5°C ;
2N sulfuric acid, 23±5°C;
70% isopropanol, 23±5°C;
Methyl ethyl ketone, 23±5°C.

    4) Moisture absorption rate: 2.6.2. Moisture Absorption
    5) Uniformity before and after etching:
The copper clad laminate containing polyimide was cut by 25 cm x 25 cm. The section was put on a flat table and measured the heights of each edge to make an average. After etching the copper, the average height was also measured like the above. When the average is not more than 0.5 cm, uniformity before and after etching is regarded as appropriate.

**Industrial Applicability**

As explained hereinbefore, the double layer metallic laminate prepared by the method of the present invention has excellent adhesive force, moisture absorption rate, thermal contraction percentage, and chemical resistance, in addition to uniformity before and after etching and high productivity.

**Claims**

1. A metallic laminate consisting of a conductor layer, a first polyimide resin layer whose thermal expansion coefficient is 5-16 ppm/°C, a second polyimide resin layer whose thermal expansion coefficient is 16-20 ppm/°C, the thermal expansion coefficients of the first and second polyimide resin layers differing by at least 3 ppm/°C, and optionally a third polyimide resin layer whose thermal expansion coefficient is more than 20 ppm/°C coated on the first and second polyimide resin layers, the difference between the thermal expansion coefficient of the second polyimide resin layer and the thermal expansion coefficient of the third polyimide resin layer being at least 10 ppm/°C. wherein the first and second polyimide resin layers are produced from polyimide precursor solutions prepared from

EP 1 791 692 B1

one or more dianhydrides selected from pyromellitic dianhydride (PMDA), 3,3,4,4-biphenyltetracarboxylic dianhydride (BPDA), 3,3,4,4-benzophenontetracarboxylic dianhydride (BTDA), 4,4-oxydiphthalic anhydride (ODPA), 4,4-(4,4-isopropylbiphenoxy)biphthalic anhydride (BPADA), 2,2-bis-(3,4-dicarboxylphenyl) hexafluoropropane dianhydride (6FDA) and ethyleneglycol bis (anhydro-trimellitate (TMEG), and one or more diamines selected from p-phenylenediamine (p-PDA), m-phenylenediamine (m-PDA), 4,4-oxydianiline (4,4-ODA), 3,4'-oxydianiline (3,4'-ODA), 2,2-bis(4-[4-aminophenoxy]-phenyl)propane (BAPP), 1,3-bis(4-aminophenoxy)benzene (TPE-R), 2,2-bis(4-[3-aminophenoxy]phenyl)sulfone (m-BAPS), 3,3'-dihydroxy-4,4'-diamino biphenyl (HAB) and 4,4'-diaminobenzanilide (DABA), the dianhydride and the diamine being mixed in a molar ratio 1 : 0.9-1.1 in an organic solvent.

2. The metallic laminate according to Claim 1, wherein the ratio of the thickness of the first polyimide resin layer to the thickness of the second polyimide resin is 1:0.01-100.

3. The metallic laminate according to Claim 1, wherein the conductor layer is copper foil.

4. A method for preparing a metallic laminate comprising the steps of:

(i) coating a metal foil with a polyimide precursor solution,
(ii) drying the solution,
(iii) coating with another polyimide precursor solution,
(iv) drying the solution, and
(v) hardening to load two polyimide resin layers on the metal foil,
one polyimide resin layer (I) having a thermal expansion coefficient of 5-16 ppm/°C and the other polyimide resin layer (II) having a thermal expansion coefficient of 16-20 ppm/°C, the thermal expansion coefficients of the polyimide resin layers (I) and (II) differing by at least 3 ppm/°C,
wherein the first and second polyimide resin layers are produced from a polyimide precursor solutions prepared from one or more dianhydrides selected from pyromellitic dianhydride (PMDA), 3,3,4,4-biphenyltetracarboxylic dianhydride (BPDA), 3,3,4,4-benzophenontetracarboxylic dianhydride (BTDA), 4,4-oxydiphthalic anhydride (ODPA), 4,4-(4,4-isopropylbiphenoxy)biphthalic anhydride (BPADA), 2,2-bis-(3,4-dicarboxylphenyl) hexafluoropropane dianhydride (6FDA) and ethyleneglycol bis(anhydro-trimellitate (TMEG), and one or more diamines selected from p-phenylenediamine (p-PDA), m-phenylenediamine (m-PDA), 4,4-oxydianiline (4,4-ODA), 3,4'-oxydianiline (3,4'-ODA), 2,2-bis(4-[4-aminophenoxy]-phenyl)propane (BAPP), 1,3-bis(4-aminophenoxy)benzene (TPE-R), 2,2-bis(4-[3-aminophenoxy]phenyl)sulfone (m-BAPS), 3,3'-dihydroxy-4,4'-diamino biphenyl (HAB) and 4,4'-diaminobenzanilide (DABA), the dianhydride and the diamine being mixed in a molar ratio 1 : 0.9-1.1 in an organic solvent.

5. The method according to Claim 4, further comprising the steps of coating the metal foil coated with both polyimide precursor solutions with a third polyimide precursor solution, and drying the solution, the third polyimide precursor solution forming a polyimide resin layer (III) whose thermal expansion coefficient is more than 20 ppm/°C, the thermal expansion coefficients of layers (III) and (II) differing by at least 10 ppm/°C.

6. The method according to Claim 4 or Claim 5, wherein the ratio of the thickness of the polyimide resin layer (I) to the thickness of the polyimide resin layer (II) is 1:0.01-100.

7. The method according to Claim 4 or Claim 5, wherein the metal foil is copper foil.

**Patentansprüche**

1. Metallisches Laminat, bestehend aus einer Leiterschicht, einer ersten Polyimidharzschicht, deren Wärmeausdehnungskoeffizient 5 bis 16 ppm/°C beträgt, einer zweiten Polyimidharzschicht, deren Wärmeausdehnungskoeffizient 16 bis 20 ppm/°C beträgt, wobei die Wärmeausdehnungskoeffizienten der ersten und zweiten Polyimidharzschichten um zumindest 3 ppm/°C differieren, und gegebenenfalls einer dritten Polyimidharzschicht, deren Wärmeausdehnungskoeffizient mehr als 20 ppm/°C beträgt, die auf den ersten und zweiten Polyimidharzschichten beschichtet ist, wobei die Differenz zwischen dem Wärmeausdehnungskoeffizienten der zweiten Polyimidharzschicht und dem Wärmeausdehnungskoeffizienten der dritten Polyimidharzschicht zumindest 10 ppm/°C beträgt, wobei die ersten und zweiten Polyimidharzschichten aus Polyimidvorläuferlösungen hergestellt sind, die aus einem oder mehreren Dianhydrid(en), ausgewählt aus Pyromellitsäuredianhydrid (PMDA), 3,3,4,4-Biphenyltetracarbonsäuredianhydrid (BPDA), 3,3,4,4-Benzophenontetracarbonsäuredianhydrid (BTDA), 4,4-Oxydiphthalsäureanhydrid (ODPA), 4,4-(4,4-Isopropylbiphenoxy)biphthalsäureanhydrid (BPADA), 2,2-Bis-(3,4-dicarboxylphenyl)hexafluorpropandianhydrid (6FDA) und Ethylenglykolbis(anhydro-trimellitat (TMEG), und einem oder mehreren Diamin(en), ausgewählt aus p-Phenylendiamin (p-PDA), m-Phenylendiamin (m-PDA), 4,4-Oxydianilin (4,4-ODA), 3,4'-Oxydianilin (3,4'-ODA), 2,2-Bis(4-[4-aminophenoxy]-phenyl)propan (BAPP), 1,3-Bis(4-aminophenoxy)benzol (TPE-R), 2,2-Bis(4-[3-aminophenoxy]phenyl)sulfon (m-BAPS), 3,3'-Dihydroxy-4,4'-diaminobiphenyl (HAB) und 4,4'-Diaminobenzanilid (DABA), hergestellt sind, wobei das Dianhydrid und das Diamin in einem Molverhältnis von 1:0,9-1,1 in einem organischen Lösungsmittel gemischt werden.

**2.** Metallisches Laminat gemäss Anspruch 1, wobei das Verhältnis der Dicke der ersten Polyimidharzschicht zur Dicke des zweiten Polyimidharzes 1:0,01-100 beträgt.

**3.** Metallisches Laminat gemäss Anspruch 1, wobei die Leiterschicht eine Kupferfolie ist.

**4.** Verfahren zur Herstellung eines metallischen Laminats, umfassend die Schritte:

(i) Beschichten einer Metallfolie mit einer Polyimidvorläuferlösung,
(ii) Trocknen der Lösung,
(iii) Beschichten mit einer anderen Polyimidvorläuferlösung,
(iv) Trocknen der Lösung, und
(v) Härten, um zwei Polyimidharzschichten auf die Metallfolie zu laden,
wobei eine Polyimidharzschicht (I) einen Wärmeausdehnungskoeffizienten von 5 bis 16 ppm/°C aufweist und die andere Polyimidharzschicht (II) einen Wärmeausdehnungskoeffizienten von 16 bis 20 ppm/°C aufweist und die Wärmeausdehnungskoeffizienten der Polyimidharzschichten (I) und (II) um zumindest 3 ppm/°C differieren, wobei die ersten und zweiten Polyimidharzschichten aus Polyimidvorläuferlösungen hergestellt sind, die aus einem oder mehreren Dianhydrid(en), ausgewählt aus Pyromellitsäuredianhydrid (PMDA), 3,3,4,4-Biphenyltetracarbonsäuredianhydrid (BPDA), 3,3,4,4-Benzophenontetracarbonsäuredianhydrid (BTDA), 4,4-Oxydiphthalsäureanhydrid (ODPA), 4,4-(4,4-Isopropylbiphenoxy)biphthalsäureanhydrid (BPADA), 2,2-Bis-(3,4-dicarboxylphenyl)hexafluorpropandianhydrid (6FDA) und Ethylenglykolbis(anhydro-trimellitat (TMEG), und einem oder mehreren Diamin(en), ausgewählt aus p-Phenylendiamin (p-PDA), m-Phenylendiamin (m-PDA), 4,4-Oxydianilin (4,4-ODA), 3,4'-Oxydianilin (3,4'-ODA), 2,2-Bis(4-[4-aminophenoxy]-phenyl)propan (BAPP), 1,3-Bis(4-aminophenoxy)benzol (TPE-R), 2,2-Bis(4-[3-aminophenoxy]phenyl)sulfon (m-BAPS), 3,3'-Dihydroxy-4,4'-diaminobiphenyl (HAB) und 4,4'-Diaminobenzanilid (DABA), hergestellt sind, wobei das Dianhydrid und das Diamin in einem Molverhältnis von 1:0,9-1,1 in einem organischen Lösungsmittel gemischt werden.

**5.** Verfahren gemäss Anspruch 4, das ferner die Schritte umfasst: Beschichten der mit beiden Polyimidvorläuferlösungen beschichteten Metallfolie mit einer dritten Polyimidvorläuferlösung und Trocknen der Lösung, wobei die dritte Polyimidvorläuferlösung eine Polyimidharzschicht (III) bildet, deren Wärmeausdehnungskoeffizient mehr als 20 ppm/°C beträgt, wobei die Wärmeausdehnungskoeffizienten der Schichten (III) und (II) um zumindest 10 ppm/°C differieren.

**6.** Verfahren gemäss Anspruch 4 oder Anspruch 5, wobei das Verhältnis der Dicke der Polyimidharzschicht (I) zur Dicke der Polyimidharzschicht (II) 1:0,01-100 beträgt.

**7.** Verfahren gemäss Anspruch 4 oder Anspruch 5, wobei die Metallfolie eine Kupferfolie ist.

**Revendications**

**1.** Stratifié métallique constitué d'une couche conductrice, d'une première couche de résine polyimide dont le coefficient de dilatation thermique est de 5 à 16 ppm/°C, d'une deuxième couche de résine polyimide dont le coefficient de dilatation thermique est de 16 à 20 ppm/°C, les coefficients de dilatation thermique des première et deuxième couches de résine polymide différant d'au moins 3 ppm/°C, et d'éventuellement une troisième couche de résine polyimide dont le coefficient de dilatation thermique est supérieur à 20 ppm/°C revêtue sur les première et deuxième couches de résine polyimide, la différence entre le coefficient de dilatation thermique de la deuxième couche de résine polyimide et le coefficient de dilatation thermique de la troisième couche de résine polyimide étant au moins de 10 ppm/°C,
dans lequel les première et deuxième couches de résine polyimide sont produites à partir de solutions de précurseur de polyimide préparées à partir d'un ou de plusieurs dianhydrides choisis parmi dianhydride pyromellitique (PMDA), dianhydride 3,3,4,4-biphényltétracarboxylique (BPDA), dianhydride 3,3,4,4-benzophénontétracarboxylique (BTDA), anhydride 4,4-oxydiphtalique (ODPA), anhydride 4,4-(4,4-isopropylbiphénoxy)biphtalique (BPADA), dianhydride de 2,2-bis-(3,4-dicarboxyphényl)hexafluoropropane (6FDA) et bis(anhydro-trimellitate) d'éthylèneglycol (TMEG), et une ou plusieurs diamines choisies parmi p-phénylènediamine (p-PDA), m-phénylènediamine (m-PDA), 4,4-oxydianiline (4,4-ODA), 3,4'-oxydianiline (3,4'-ODA), 2,2-bis(4-[4-aminophénoxy]-phényl)propane (BAPP), 1,3-bis(4-aminophénoxy)benzène (TPE-R), 2,2-bis(4-[3-aminophénoxy]phényl)sulfone (m-BAPS), biphényle de 3,3'-dihydroxy-4,4'-diamino (HAB) et 4,4'-diaminobenzalide (DABA), le dianhydride et la diamine étant mélangés dans un rapport molaire 1:0,9-1,1 dans un solvant organique.

2. Stratifié métallique selon la revendication 1, dans lequel le rapport de l'épaisseur de la première couche de résine polyimide sur l'épaisseur de la deuxième résine polyimide est de 1:0,01-100.

3. Stratifié métallique selon la revendication 1, dans lequel la couche conductrice est une feuille de cuivre.

4. Procédé de préparation d'un stratifié métallique comprenant les étapes de :

    (i) revêtement d'une feuille métallique avec une solution de précurseur de polyimide,
    (ii) séchage de la solution,
    (iii) revêtement avec une autre solution de précurseur de polyimide,
    (iv) séchage de la solution, et
    (v) durcissement pour charger deux couches de résine polyimide sur la feuille métallique,
    une couche de résine polyimide (I) ayant un coefficient de dilatation thermique est de 5-16 ppm/°C et l'autre couche de résine polyimide (II) ayant un coefficient de dilatation thermique de 16-20 ppm/°C, les coefficients de dilatation thermique des couches de résine polymide (I) et (II) différant d'au moins 3 ppm/°C,
    dans lequel les première et deuxième couches de résine polyimide sont produites à partir de solutions de précurseur de polyimide préparées à partir d'un ou de plusieurs dianhydrides choisis parmi dianhydride pyromellitique (PMDA), dianhydride 3,3,4,4-biphényltétracarboxylique (BPDA), dianhydride 3,3,4,4-benzophénontétracarboxylique (BTDA), anhydride 4,4-oxydiphtalique (ODPA), anhydride 4,4-(4,4-isopropylbiphénoxy)biphtalique (BPADA), dianhydride de 2,2-bis-(3,4-dicarboxyphényl)hexafluoropropane (6FDA) et bis(anhydro-trimellitate) d'éthylèneglycol (TMEG), et une ou plusieurs diamines choisies parmi p-phénylènediamine (p-PDA), m-phénylènediamine (m-PDA), 4,4-oxydianiline (4,4-ODA), 3,4'-oxydianiline (3,4'-ODA), 2,2-bis(4-[4-aminophénoxy]-phényl)propane (BAPP), 1,3-bis(4-aminophénoxy)benzène (TPE-R), 2,2-bis(4-[3-aminophénoxy]phényl)sulfone (m-BAPS), biphényle de 3,3'-dihydroxy-4,4'-diamino (HAB) et 4,4'-diaminobenzalide (DABA), le dianhydride et la diamine étant mélangés dans un rapport molaire 1:0,9-1,1 dans un solvant organique.

5. Procédé selon la revendication 4, comprenant en outre les étapes de revêtement de la feuille métallique revêtue avec les deux solutions de précurseur de polyimide avec une troisième solution de précurseur de polyimide, et de séchage de la solution , la troisième solution de précurseur de polyimide formant une couche de résine polyimide (III) dont le coefficient de dilatation thermique est supérieur à 20 ppm/°C, les coefficients de dilatation thermique des couches (III) et (II) différant d'au moins 10 ppm/°C.

6. Procédé selon la revendication 4 ou la revendication 5, dans lequel le rapport de l'épaisseur de la couche de résine polyimide (I) sur l'épaisseur de la couche de résine polyimide (II) est de 1:0,01-100.

7. Procédé selon la revendication 4 ou la revendication 5, dans lequel la feuille métallique est une feuille de cuivre.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 200073384
- EP 0498898 A
- JP 1244841 A
- EP 0335337 A